(19) Europäisches Patentamt / European Patent Office / Office européen des brevets

(11) **EP 3 810 988 B1**

(12) **EUROPÄISCHE PATENTSCHRIFT**

(45) Veröffentlichungstag und Bekanntmachung des Hinweises auf die Patenterteilung:
**04.08.2021** **Patentblatt 2021/31**

(21) Anmeldenummer: **20747390.1**

(22) Anmeldetag: **28.07.2020**

(51) Int Cl.:
*F21V 29/503* (2015.01)     *F21V 29/58* (2015.01)
*F21V 29/83* (2015.01)     *H05K 1/02* (2006.01)
*H01L 33/64* (2010.01)     *F21Y 115/10* (2016.01)

(86) Internationale Anmeldenummer:
**PCT/EP2020/071189**

(87) Internationale Veröffentlichungsnummer:
**WO 2021/037459 (04.03.2021 Gazette 2021/09)**

(54) **STRAHLER UND VERFAHREN ZUM ABSTRAHLEN VON LICHT**

EMITTER AND METHOD FOR EMITTING LIGHT

ÉMETTEUR ET PROCÉDÉ D'ÉMISSION DE LUMIÈRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.08.2019   DE 102019213150**

(43) Veröffentlichungstag der Anmeldung:
**28.04.2021   Patentblatt 2021/17**

(73) Patentinhaber: **Würth Elektronik eiSos GmbH & Co. KG**
**74638 Waldenburg (DE)**

(72) Erfinder:
• **ANDREEV, Zhelio**
  **74523 Schwäbisch Hall (DE)**
• **DÖRR, Marcel**
  **71642 Ludwigsburg (DE)**

(74) Vertreter: **Rau, Schneck & Hübner**
**Patentanwälte Rechtsanwälte PartGmbB**
**Königstraße 2**
**90402 Nürnberg (DE)**

(56) Entgegenhaltungen:
EP-A1- 1 780 804     US-A1- 2003 052 584
US-A1- 2005 094 397     US-A1- 2008 191 236
US-A1- 2012 044 678     US-A1- 2017 009 961

EP 3 810 988 B1

**Beschreibung**

Die Erfindung betrifft einen Strahler zum Abstrahlen von Licht, insbesondere von sichtbaren Licht, Infrarotlicht und/oder UV-Licht. Insbesondere betrifft die Erfindung eine Leuchte zum Abstrahlen von sichtbarem Licht. Ferner betrifft die Erfindung ein Verfahren zum Abstrahlen von Licht mittels eines Strahlers.

Aus der EP 1 681 728 A1 ist eine Leuchte mit LED-Leuchtelementen bekannt, die ultraviolettes Licht (UV-Licht) erzeugen. Über eine Lichtwandeleinheit wird das UV-Licht in sichtbares Licht gewandelt. Zur Kühlung der Lichtwandeleinheit ist ein Wärmeableitungselement vorgesehen. Aus der DE 10 2007 054 039 A1 ist eine Leuchtdiode bekannt, bei der Flüssigkeit zur Lichtkonversion verwendet wird. Die DE 10 2010 007 687 A1 beschreibt eine LED-Lampe mit einem Wärmerohr als Kühlung. Die US 2005/0094397 A1 beschreibt eine Lichtquelle und einen Projektor. Die Druckschriften US 2008/0191236 A1, US 2003/0052584 A1, US 2017/0009961 A1, EP 1 780 804 A1 und US 2012/0044678 A1 beschreiben Strahler zum Abstrahlen von Licht.

Es ist die Aufgabe der vorliegenden Erfindung, einen verbesserten Strahler zur Abstrahlung von Licht zu schaffen. Es soll insbesondere ein Strahler bereitgestellt werden, der effizient und konstruktiv einfach ist.

Diese Aufgabe ist gelöst durch einen Strahler mit den in Anspruch 1 angegebenen Merkmalen. Der Strahler weist ein Substrat mit einer Substrat-Oberfläche auf. Mindestens ein LED-Element zur Erzeugung des abzustrahlenden Lichts ist auf der Substrat-Oberfläche angeordnet. Der Strahler weist eine aktive Kühleinheit zur Kühlung des mindestens einen LED-Elements mit mindestens einem Kühlkanal für ein Kühlmittel auf. Der mindestens eine Kühlkanal ist in einem Strahlengang von zumindest einem Teil des mittels des mindestens einen LED-Elements erzeugbaren abzustrahlenden Lichts zur Umlenkung des abzustrahlenden Lichts angeordnet. Der mindestens eine Kühlkanal ist insbesondere an der Substrat-Oberfläche angeordnet. Erfindungsgemäß wurde erkannt, dass der mindestens eine zur Kühlung des mindestens einen LED-Elements verwendete Kühlkanal auch zur Umlenkung des mittels des LED-Elements erzeugbaren Lichts nutzbar ist. Hierdurch kann die Abstrahlcharakteristik des Strahlers auf einfache Weise angepasst werden. Auf die Verwendung weiterer Optiken kann verzichtet werden. Der Strahler ist effizient und weist einen einfachen Aufbau auf.

Das durch das mindestens eine LED-Element erzeugbare Licht breitet sich im Regelfall gleichmäßig über den gesamten Raumwinkelbereich von $2\pi$ oberhalb der Substrat-Oberfläche aus. Durch die Umlenkung zumindest eines Teils des Lichts mittels des mindestens einen Kühlkanals ist die Verteilung des Lichts, insbesondere der abgedeckte Raumwinkelbereich, veränderbar. Die Umlenkung des Lichts erfolgt beispielsweise durch Reflexion und/oder Brechung des Lichts an dem mindestens einen Kühlkanal.

Durch die Umlenkung zumindest eines Teils des Lichts durch den mindestens einen Kühlkanal ist insbesondere eine Bündelung des durch den Strahler abzustrahlenden Lichts möglich. Unter Bündelung wird verstanden, dass der Raumwinkelbereich, in welchen der Strahler Licht abstrahlt, verringert wird. Hierdurch wird die Intensität des abgestrahlten Lichts in dem abgedeckten Raumwinkelbereich erhöht. Der Strahler leuchtet einen vordefinierten Raumwinkelbereich effizient aus.

Der Strahler dient zur Abstrahlung von Licht. Das mindestens eine LED-Element erzeugt bei Verwendung des Strahlers direkt das abzustrahlende Licht. Dies bedeutet, dass der Strahler das Licht in dem Frequenzbereich abstrahlt, der von dem mindestens einen LED-Element erzeugbar ist. Eine Umwandlung bzw. Frequenzänderung des mittels des mindestens einen LED-Elements erzeugten Lichts ist nicht erforderlich. Die Umlenkung des abzustrahlenden Lichts erfolgt ohne Änderung der Frequenz des abzustrahlenden Lichts. Erfindungsgemäß wird das mittels des mindestens einen LED-Elements erzeugte Licht nicht durch eine Lichtwandeleinheit absorbiert und in einen anderen Frequenzbereich gewandelt. Dementsprechend erfolgt die Umlenkung zumindest eines Teils des Lichts durch den mindestens einen Kühlkanal ohne Änderung der Frequenz des durch das mindestens eine LED-Element erzeugten Lichts. Die Effizienz des Strahlers ist verbessert. Das abzustrahlende Licht ist insbesondere sichtbares Licht, Infrarotlicht und/oder UV-Licht. Das abzustrahlende Licht kann beispielsweise eine Frequenz zwischen 180 THz und 3000 THz aufweisen. Sichtbares Licht ist elektromagnetische Strahlung in einem Frequenzbereich, der durch das menschliche Auge wahrgenommen werden kann. Im Allgemeinen erstreckt sich der sichtbare Frequenzbereich von etwa 400 THz bis etwa 790 THz. Zur Abstrahlung von sichtbaren Licht wird dieses direkt durch das LED-Element erzeugt. Eine Umwandlung von mittels des LED-Elements erzeugter elektromagnetischer Strahlung in sichtbares Licht erfolgt nicht. Insbesondere findet keine Umwandlung von mittels eines LED-Elements erzeugtem UV-Licht in sichtbares Licht statt. Ein Strahler zum Abstrahlen von sichtbaren Licht dient zur Beleuchtung und wird auch als Leuchte oder Luminaire bezeichnet. Bevorzugt deckt das abzustrahlende Licht den sichtbaren Frequenzbereich ab. Besonders bevorzugt ist das abzustrahlende Licht Weißlicht. Der Strahler kann eine Weißlicht-Leuchte sein.

Strahler zur Abstrahlung von Infrarotlicht können beispielsweise zur Infrarotbeleuchtung bei Überwachungskameras, für Bilderkennungs- und Überwachungssysteme und für Datenübertragungssysteme eingesetzt werden. Besonders geeignet ist Infrarotlicht im nahen Infrarotbereich. Es weist beispielsweise eine Frequenz zwischen etwa 180 THz und etwa 399 THz auf.

Strahler zur Abstrahlung von UV-Licht werden beispielsweise zur Desinfektion, UV-Aushärtung und UV-Trocknung eingesetzt. Besonders geeignet ist UV-Licht im nahen und mittleren UV-Bereich. Geeignetes UV-Licht kann beispielsweise eine Frequenz zwischen etwa 791 THz und etwa 3000 THz aufweisen. LED-Elemente zur Erzeugung von UV-Licht weisen regelmäßig einen nur geringen Wirkungsgrad auf, beispielsweise einen Wirkungsgrad von kleiner 20 %. Daher ist ein durch die Umlenkung, insbesondere Bündelung des abzustrahlenden Lichts erzielbarer Effizienzgewinn für Strahler zur Abstrahlung von UV-Licht besonders vorteilhaft.

Das Substrat ist insbesondere eine Leiterplatte. Das Substrat weist eine Substrat-Oberfläche auf, auf welcher das mindestens eine LED-Element angeordnet ist. Das Substrat weist insbesondere eine weitere Substrat-Oberfläche auf, die von der ersten Substrat-Oberfläche um eine SubstratDicke beabstandet ist. Zur genaueren Unterscheidung werden im Folgenden die Substrat-Oberfläche, auf der das mindestens eine LED-Element angeordnet ist, auch als erste Substrat-Oberfläche beziehungsweise die weitere Substrat-Oberfläche, an der das mindestens eine LED-Element nicht angeordnet ist, als zweite Substrat-Oberfläche bezeichnet. Wird im Folgenden lediglich auf "die Substrat-Oberfläche" Bezug genommen, ist die Substrat-Oberfläche gemeint, auf welcher das mindestens eine LED-Element angeordnet ist.

Der Strahler weist mindestens ein LED-Element, insbesondere mehrere LED-Elemente auf. Im Falle mehrerer LED-Elemente können diese beliebig auf der ersten Substrat-Oberfläche angeordnet sein. Bevorzugt sind mehrere LED-Elemente in regelmäßigen Abständen auf der ersten Substrat-Oberfläche angeordnet.

Das mindestens eine LED-Element kann jeweils eine oder mehrere LEDs aufweisen. Das mindestens eine LED-Element weist insbesondere mindestens einen LED-Chip, insbesondere einen High-Power-Chip, auf. Insbesondere wenn mit dem LED-Element sichtbares Licht erzeugbar ist, wird das LED-Element auch als LED-Leuchtmittel bezeichnet. Zur Abstrahlung sichtbaren Lichts kann das LED-Leuchtmittel insbesondere einen LED-Chip aufweisen, mit dem sichtbares Licht, insbesondere ausschließlich sichtbares Licht erzeugbar ist. Alternativ oder zusätzlich hierzu kann mittels mindestens eines LED-Chips Licht im nicht sichtbaren Bereich erzeugbar sein. Gegebenenfalls kann das mindestens eine LED-Leuchtmittel eine Lichtwandeleinheit umfassen, über welche das mittels des mindestens einen LED-Chips erzeugte Licht in sichtbares Licht gewandelt wird.

Die aktive Kühleinheit dient zur Kühlung des mindestens einen LED-Elements. Die aktive Kühleinheit weist mindestens einen Kühlkanal für ein Kühlmittel, insbesondere eine Kühlflüssigkeit, auf. Das Kühlmittel wird in dem mindestens einen Kühlkanal insbesondere durch eine Pumpe der aktiven Kühleinheit gepumpt.

Der mindestens eine Kühlkanal ist an der bzw. benachbart zu der ersten Substrat-Oberfläche angeordnet. Der mindestens eine Kühlkanal ist an derselben Substrat-Oberfläche wie das mindestens eine LED-Element angeordnet. Die Kühlung des mindestens einen LED-Elements erfolgt direkt. Eine Wärmeabfuhr über das Substrat, beispielsweise zu an der zweiten Substrat-Oberfläche angeordneten Kühlkanälen, ist nicht nötig. Die Kühlung des mindestens einen LED-Elements ist effizient.

Die aktive Kühleinheit weist insbesondere mehrere Kühlkanäle, bevorzugt ein Netzwerk aus Kühlkanälen, auf. Der Verlauf der Kühlkanäle kann an eine Anordnung mehrerer LED-Elemente auf der ersten Substrat-Oberfläche angepasst sein. Insbesondere verlaufen mehrere Kühlkanäle an der ersten Substrat-Oberfläche zwischen den LED-Elementen.

Das mindestens eine LED-Element und der mindestens eine Kühlkanal sind in einer transparenten Einkapselung eingebettet. Der Strahler ist stabil und einfach fertigbar. Die transparente Einkapselung schützt das mindestens eine LED-Element und den mindestens einen Kühlkanal. Beschädigungen werden vermieden. Die Einkapselung weist insbesondere eine Abstrahl-Oberfläche auf, an welcher das mittels des Strahlers abzustrahlende Licht austritt. Die Abstrahl-Oberfläche ist insbesondere parallel zu der Substrat-Oberfläche ausgebildet. Die Abstrahl-Oberfläche ist insbesondere senkrecht zu der Hauptabstrahlrichtung.

Die Einkapselung weist ein Silikon-Elastomer und/oder ein Harz, insbesondere ein Epoxidharz, auf. Der Strahler ist günstig und einfach fertigbar. Harze, insbesondere Epoxidharze, und/oder Silikon-Elastomere können auf einfache Weise aufgebracht und ausgehärtet werden. Die Geometrie der Einkapselung, insbesondere die Form der Abstrahl-Oberfläche, ist vorteilhafterweise an die jeweiligen Anforderungen, insbesondere die gewünschte Lampenform, einfach und flexibel anpassbar.

Ein Strahler nach Anspruch 2 gewährleistet eine gezielte und effiziente Umlenkung, insbesondere Bündelung, des Lichts. Die Hauptabstrahlrichtung ist insbesondere senkrecht zu der Substrat-Oberfläche definiert. Eine Ablenkung in Richtung der Hauptabstrahlrichtung ist derart zu verstehen, dass eine Komponente der Ausbreitungsrichtung des Strahlengangs des Lichts in Hauptabstrahlrichtung vergrößert wird. Beispielsweise weist der Strahlengang von mittels des LED-Elements erzeugbaren Lichts einen Abstrahlwinkel b zu der Hauptabstrahlrichtung auf, wobei gilt: $0° \leq b \leq 90°$. Für $b \neq 0°$ verläuft der Strahlengang nicht parallel zur Hauptabstrahlrichtung. Gegebenenfalls bewirkt die Ablenkung in Hauptabstrahlrichtung insbesondere einen abgelenkten Strahlengang, der zu der Hauptabstrahlrichtung einen Winkel b' hat, wobei gilt: $0° \leq b' < b$. Die Lichtintensität in Richtung der Hauptabstrahlrichtung ist erhöht.

Ein Strahler nach Anspruch 3 gewährleistet eine besonders effiziente Umlenkung, insbesondere Bündelung, des abzustrahlenden Lichts. Die Reflexion an der Kühlkanal-Grenzfläche des mindestens einen Kühlkanals bewirkt eine gezielte und kontrollierte Umlenkung zumindest eines Teils des abzustrahlenden Lichts. Das an dem mindestens einen Kühlkanal reflektierte Licht dringt nicht in den Kühlkanal ein und erfährt hierdurch keine Abschwächung. Die Reflexion mindestens eines Teils des Lichts kann auch durch Totalreflexion des Lichts an der Kühlkanal-Grenzfläche erfolgen.

Zusätzlich oder alternativ kann ein Bereich der Kühlkanal-Grenzfläche, auf den mindestens ein Teil des mittels des mindestens einen LED-Elements erzeugbaren Lichts trifft, verspiegelt sein.

Ein Strahler nach Anspruch 4 gewährleistet eine direkte und effiziente Kühlung bei gleichzeitig hoher Lichtausbeute. Die benachbarte Anordnung des mindestens einen Kühlkanals und des mindestens einen LED-Elements hat weiterhin den Vorteil, dass seitlich von dem mindestens einen LED-Element ausgehendes Licht effizient umlenkbar ist. Der mindestens eine Kühlkanal kann auf der durch die Substrat-Oberfläche gebildeten Ebene direkt oder beabstandet benachbart zu dem mindestens einen LED-Element angeordnet sein. Der mindestens eine Kühlkanal ist insbesondere direkt auf der Substrat-Oberfläche angeordnet.

Bevorzugt weisen der mindestens eine Kühlkanal und das mindestens eine LED-Element senkrecht zu der Substrat-Oberfläche keinen Überlapp auf. Besonders bevorzugt weisen der mindestens eine Kühlkanal und das mindestens eine LED-Element in der Hauptabstrahlrichtung keinen Überlapp auf. Das senkrecht zu der Substrat-Oberfläche abgestrahlte Licht, insbesondere das in Hauptabstrahlrichtung abgestrahlte Licht, erfährt keine Schwächung und/oder Umlenkung durch den mindestens einen Kühlkanal. Die Ausbeute des abzustrahlenden Lichts ist insbesondere in Hauptabstrahlrichtung verbessert.

Ein Strahler nach Anspruch 5 gewährleistet eine effiziente Kühlung des mindestens einen LED-Elements. Zudem ist ein größerer Anteil des mittels des mindestens einen LED-Elements erzeugbaren Lichts in Richtung senkrecht zu der Substrat-Oberfläche, insbesondere in Hauptabstrahlrichtung, umlenkbar. Die Bündelung des Lichts ist weiter verbessert. Hier und im Folgenden ist unter "angrenzen" zu verstehen, dass das mindestens eine LED-Element direkt oder beabstandet benachbart zu dem mindestens einen Kühlkanal angeordnet ist.

Bevorzugt grenzt das mindestens eine LED-Element an mindestens drei Seiten, insbesondere an allen Seiten, in der durch die Substrat-Oberfläche definierten Ebene an den mindestens einen Kühlkanal an. Besonders bevorzugt ist das mindestens eine LED-Element von dem mindestens einen Kühlkanal in der Ebene der ersten Substrat-Oberfläche vollumfänglich umgeben. An verschiedenen Seiten des LED-Elements kann der gleiche Kühlkanal, beispielsweise ein um das mindestens eine LED-Element gebogener Kühlkanal, angrenzen. Alternativ können an verschiedenen Seiten unterschiedliche Kühlkanäle an das mindestens eine LED-Element angrenzen.

Ein Strahler nach Anspruch 6 weist eine hohe Lichtausbeute und eine präzise definierte Abstrahlcharakteristik auf. Die sich von dem jeweils benachbarten LED-Element weg erstreckenden Bereiche der Kühlkanal-Grenzfläche des mindestens einen Kühlkanals definieren ausgehend von der Substrat-Oberfläche einen sich öffnenden Abstrahlbereich bzw. Lichtkegel.

Ein Strahler nach Anspruch 7 ist einfach und flexibel fertigbar. Die Geometrie der Kühlkanäle, insbesondere deren Querschnitt, ist flexibel festlegbar. Die als Hohlraum in der Einkapselung ausgebildeten Kühlkanäle weisen insbesondere keine zusätzliche Kühlkanal-Einhausung, insbesondere keine separat ausgebildeten Kühlkanal-Seitenwände auf. Der Wärmetransport erfolgt insbesondere direkt von dem mindestens einen LED-Element über die Einkapselung zu dem Kühlmittel in dem Kühlkanal. Die Kühlwirkung ist verbessert.

Ein Strahler nach Anspruch 9 gewährleistet eine effiziente Umlenkung zumindest eines Teils des Lichts. Da der Brechungsindex $n_E$ der Einkapselung größer ist als der Brechungsindex $n_K$ des Kühlmittels, ist die Einkapselung ein optisch dichteres Medium als das Kühlmittel. Am Übergang vom optisch dichteren Medium der Einkapselung zu dem Kühlkanal ist somit eine Totalreflexion möglich. Hierdurch kann eine effiziente Reflexion zumindest eines Teils des Lichts an der Kühlkanal-Grenzfläche erfolgen, ohne dass eine Verspiegelung der Kühlkanal-Grenzfläche nötig ist. Hierdurch ist die Reflexion insbesondere ohne Einschränkungen des Wärmetransports durch die Kühlkanal-Grenzfläche möglich.

Insbesondere wenn der mindestens eine Kühlkanal als Hohlraum in der Einkapselung ausgebildet ist, entspricht ein Brechungsindex des Kühlkanals dem Brechungsindex des Kühlmittels, insbesondere der Kühlflüssigkeit. Beispielhafte Kühlmittel enthalten Wasser mit einem Brechungsindex von 1,33 und/oder Ethylenglycol mit einem Brechungsindex von 1,43.

Bevorzugt ist der Brechungsindex $n_E$ der transparenten Einkapselung größer als 1,33, insbesondere größer als 1,43, insbesondere größer als 1,45, insbesondere größer als 1,5. Die Einkapselung kann beispielsweise einen Brechungsindex $n_E$ im Bereich von 1,45 bis 1,59, insbesondere zwischen 1,45 und 1,54 aufweisen. Ein beispielhaftes Epoxidharz, das unter dem Handelsnamen "Nitto Denko NT-8524" vertrieben wird, weist einen Brechungsindex von 1,57 auf. Ein beispielhaftes Silikon-Elastomer, das unter dem Handelsnamen "Dow Corning OE-6550" vertrieben wird, weist einen Brechungsindex von 1,54 auf.

Ein Strahler nach Anspruch 10 gewährleistet eine effiziente Umlenkung des auf die Kühlkanal-Grenzfläche des mindestens einen Kühlkanals treffenden Lichts. Der Winkel d zwischen der Oberflächentangente des dem mindestens einen LED-Element zugewandten Bereichs einer Kühlkanal-Grenzfläche und der ersten Substrat-Oberfläche bestimmt die relative Neigung des Bereichs der Kühlkanal-Grenzfläche relativ zu von dem LED-Element erzeugbaren Lichts. Abhängig von dem Winkel d erfährt Licht, das unter einem bestimmten Abstrahlwinkel b zu der Hauptabstrahlrichtung abgestrahlt wird, an der Kühlkanal-Grenzfläche eine Totalreflexion. Unter der Bedingung

$$d \leq 180° - b - \sin^{-1}\left(\frac{n_K}{n_E}\right) \qquad (1)$$

wird das mit Abstrahlwinkel b zu einer senkrecht zu der ersten Substrat-oberfläche definierten Hauptabstrahlrichtung abgestrahlte Licht an der Kühlkanal-Grenzfläche totalreflektiert. Je größer der Abstrahlwinkel b ist, desto kleiner muss der Winkel d ausfallen, um Totalreflexion zu gewährleisten. Für

$$d \leq 90° - \sin^{-1}\left(\frac{n_K}{n_E}\right) \qquad (2)$$

ist gewährleistet, dass auch von dem mindestens einen LED-Element parallel zu der Substrat-Oberfläche ausgehendes Licht (b = 90°) an der Kühlkanal-Grenzfläche totalreflektiert wird.

Bevorzugt ist der dem mindestens einen LED-Element zugewandte Bereich der Kühlkanal-Grenzfläche eben ausgebildet, besonders bevorzugt verläuft der gesamte dem mindestens einen LED-Element zugewandte Bereich unter dem Winkel d zur Oberfläche. Der Winkel d beschreibt gegebenenfalls den Winkel, unter welchem der gesamte dem mindestens einen LED-Element zugewandte Bereich der Kühlkanal-Grenzfläche zu der Substrat-Oberfläche verläuft. Der Winkel d wird im Folgenden auch als Basiswinkel bezeichnet.

Ein Strahler nach Anspruch 11 ermöglicht eine kontrollierte und zuverlässige Umlenkung des Lichts. Polygonförmige Querschnitte des mindestens einen Kühlkanals weisen ebene Grenzflächen-Bereiche auf, an denen eine effiziente Umlenkung von Licht erfolgen kann. Bevorzugt weist der Querschnitt des mindestens einen Kühlkanals die Form eines Dreiecks, insbesondere eines gleichschenkligen Dreiecks, auf. Die Basis des Dreiecks liegt besonders bevorzugt parallel zu der durch die Substrat-Oberfläche gebildeten Ebene. Die Schenkel des Dreiecks erstrecken sich insbesondere von der Substrat-Oberfläche weg. Besonders bevorzugt verlaufen die Schenkel des dreieckförmigen Querschnitts des Kühlkanals unter einem Basiswinkel d zu der Substrat-Oberfläche, der die Bedingungen der Formel (2) erfüllt.

Alternativ kann der mindestens eine Kühlkanals auch gebogene Bereiche der Kühlkanal-Grenzfläche aufweisen. Beispielsweise kann der mindestens eine Kühlkanals konvex gebogene Kühlkanal-Grenzflächenbereiche aufweisen, insbesondere kuppelförmig sein. Bevorzugt weist der mindestens eine Kühlkanal konkav gebogene Bereiche der Kühlkanal-Grenzfläche auf, insbesondere konkave Seitenflächen auf. Der Querschnitt des mindestens einen Kühlkanals kann zumindest bereichsweise linsenförmig sein. Dies ermöglicht eine besonders gute Bündelung des Lichts.

Bevorzugt weist der mindestens eine Kühlkanal senkrecht zu der Substrat-Oberfläche eine Ausdehnung zwischen 1 mm und 20 mm, insbesondere zwischen 1 mm und 15 mm, auf. Ein derartiger Strahler ermöglicht eine effiziente Bündelung des Lichts. Die Ausdehnung des Kühlkanals senkrecht zu der Substrat-Oberfläche wird im Folgenden auch als Höhe des Kühlkanals bezeichnet. Mit steigender Höhe des Kühlkanals, insbesondere mit steigender Höhe des Kühlkanals bei gleichzeitig unveränderter, in Richtung der Substrat-Oberfläche gemessener Breite, verringert sich der Lichtkegel des mittels des Strahlers abzustrahlenden Lichts. Über die Höhe des Kühlkanals ist somit eine Anpassung der Abstrahlcharakteristik möglich.

Allgemein kann die Abstrahlcharakteristik abhängig von der Höhe des Kühlkanals, von der Breite des Kühlkanals, von einer in Richtung der Substrat-Oberfläche gemessenen Ausdehnung des mindestens einen LED-Elements und/oder von einem in Richtung der Substrat-Oberfläche gemessenem Abstand zwischen LED-Element und benachbarten Kühlkanal sein. Zur Anpassung der Abstrahlcharakteristik an die jeweiligen Anforderungen, insbesondere zur Optimierung der Bündelung, können die oben genannten Parameter variiert und aufeinander abgestimmt werden.

Ein Strahler nach Anspruch 12 weist eine effiziente Kühlung auf. Ethylenglycol hat sich als Kühlmittel bewährt. Ethylenglycol hat einen großen Temperaturbereich, in welchem es flüssig ist.

Es ist eine weitere Aufgabe der Erfindung, ein Verfahren zum Abstrahlen von Licht zu verbessern, insbesondere ein Verfahren zum Abstrahlen von Licht effizient und einfach zu gestalten.

Diese Aufgabe ist gelöst durch ein Verfahren mit den in Anspruch 13 angegebenen Schritten. Zunächst wird ein Strahler bereitgestellt. Der bereitgestellte Strahler weist ein Substrat mit einer Substrat-Oberfläche, mindestens ein auf der Substrat-Oberfläche angeordnetes LED-Element zur Erzeugung von abzustrahlendem Licht im sichtbaren Frequenzbereich und eine aktive Kühleinheit zur Kühlung des mindestens einen LED-Elements auf. Die aktive Kühleinheit weist mindestens einen Kühlkanal für ein Kühlmittel auf, der in einem Strahlengang von zumindest einem Teil des mittels des mindestens einen LED-Elements erzeugbaren, abzustrahlenden Lichts angeordnet ist. Das mindestens eine LED-Element und der mindestens eine Kühlkanal sind in einer transparenten Einkapselung eingebettet. Die Einkapselung weist ein Silikon-Elastomer und/oder ein Harz, insbesondere ein Epoxidharz, auf. Das abzustrahlende Licht wird im sichtbaren Frequenzbereich mittels des mindestens einen LED-Elements erzeugt. Das mindestens eine LED-Element wird mittels der aktiven Kühleinheit gekühlt. Zumindest ein Teil des abzustrahlenden Lichts wird mittels des mindestens einen Kühlkanals umgelenkt. Die Vorteile des Verfahrens entsprechen den Vorteilen des oben beschriebenen Strahlers.

Der bereitgestellte Strahler kann insbesondere einzelne oder mehrere der oben im Zusammenhang mit dem Strahler beschriebenen Merkmale aufweisen.

Ein Verfahren nach Anspruch 14 ermöglicht eine effiziente und gezielte Umlenkung, insbesondere Bündelung, des mittels des Strahlers abzustrahlenden Lichts.

Ein Verfahren nach Anspruch 15 gewährleistet eine effiziente Umlenkung mindestens eines Teils des abzulenkenden Lichts. Insbesondere bei der Totalreflexion des Lichts an der Kühlkanal-Grenzfläche des mindestens einen Kühlkanals wird das Licht durch den Kühlkanal nicht absorbiert oder in diesen transmittiert. Das Licht erfährt durch den Kühlkanal keine Abschwächung. Die Intensität des mittels des Strahlers abgestrahlten Lichts ist erhöht.

Weitere Merkmale, Vorteile und Einzelheiten der Erfindung ergeben sich aus der nachfolgenden Beschreibung mehrerer Ausführungsbeispiele. Es zeigen:

Fig. 1   eine Aufsicht eines schematisch dargestellten, ersten Ausführungsbeispiels einer Leuchte mit mehreren LED-Leuchtmitteln und einer aktiven Kühleinheit,

Fig. 2   einen Querschnitt durch die Leuchte gemäß Fig. 1 entlang der Schnittlinie II-II,

Fig. 3   ein Detail III der Schnittdarstellung gemäß Fig. 2,

Fig. 4   einen schematischen Verfahrensablauf eines Betriebsver-fahrens für die Leuchte gemäß Fig. 1,

Fig. 5   eine schematische Darstellung der Abstrahlcharakteristik der Leuchte gemäß Fig. 1,

Fig. 6   einen Querschnitt durch ein zweites Ausführungsbeispiel einer Leuchte, und

Fig. 7   einen Querschnitt durch ein drittes Ausführungsbeispiel einer Leuchte.

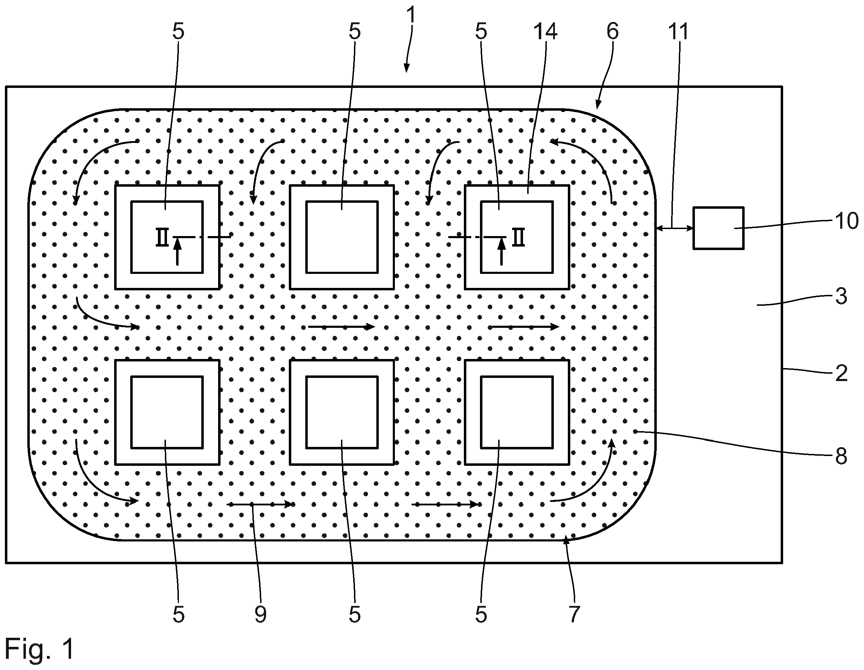

In den Fig. 1 bis 3 ist ein erstes Ausführungsbeispiel eines Strahlers in Form einer Leuchte 1 gezeigt. Die Leuchte 1 weist ein Substrat 2 mit einer ersten Substrat-Oberfläche 3 und einer von der ersten Substrat-Oberfläche 3 um eine Substratdicke beabstandete zweite Substrat-Oberfläche 4 auf. Auf der ersten Substrat-Oberfläche 3 ist eine Mehrzahl von LED-Elementen in Form von LED-Leuchtmitteln 5 angeordnet. Die Leuchte 1 weist zudem eine aktive Kühleinheit 6 mit einem Netzwerk von auf der ersten Substrat-Oberfläche 3 angeordneten Kühlkanälen 7 auf.

In dem gezeigten Ausführungsbeispiel sind sechs LED-Leuchtmittel 5 auf der ersten Substrat-Oberfläche 3 angeordnet. Die LED-Leuchtmittel 5 sind in Form eines regelmäßigen Gitters von drei mal zwei LED-Leuchtmitteln 5 auf der ersten Substrat-Oberfläche 3 angeordnet. Anzahl und Anordnung der LED-Leuchtmittel sind nicht wesentlich und können je nach Ausführungsbeispiel variieren.

Die LED-Leuchtmittel 5 dienen zur Erzeugung von durch die Leuchte 1 abzustrahlenden sichtbaren Lichts. Das mittels der LED-Leuchtmittel 5 erzeugbare Licht ist elektromagnetische Strahlung im sichtbaren Bereich. Dies bedeutet, das mittels der LED-Leuchtmittel 5 erzeugte Licht weist eine Frequenz bzw. eine Wellenlänge auf, die im Frequenzbereich bzw. Wellenlängenbereich des sichtbaren Lichts liegt. Die LED-Leuchtmittel 5 sind LED-Chips.

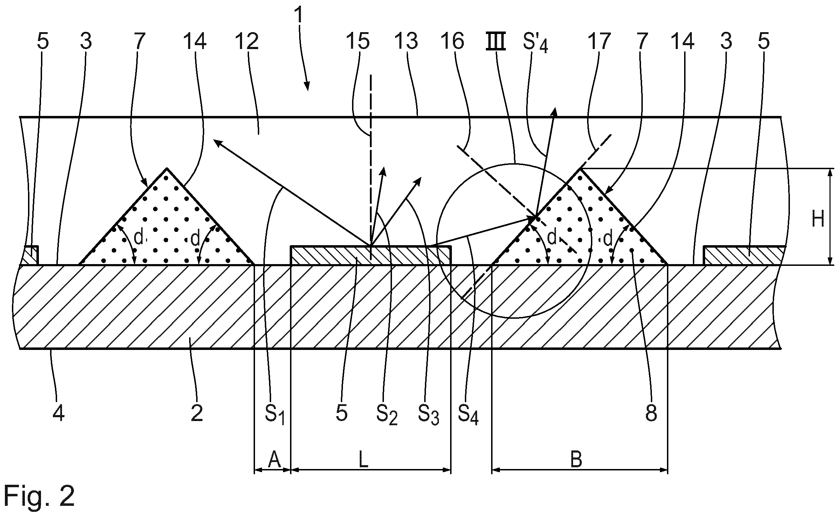

Bei der Erzeugung von Licht mittels der LED-Leuchtmittel 5 entsteht Wärme. Die aktive Kühleinheit 6 dient zur Kühlung der LED-Leuchtmittel 5. Hierfür wird ein Kühlmittel 8 in den Kühlkanälen 7 gefördert. Das Kühlmittel 8 ist als Kühlflüssigkeit ausgeführt, welche in den Fig. 1 und 2 schematisch durch Punkte dargestellt ist. Das Kühlmittel 8 fließt in den Kühlkanälen 7 entlang der in Fig. 1 symbolisch durch die Pfeile 9 angedeuteten Fließrichtung. Zum Pumpen bzw. Fördern des Kühlmittels 8 in den Kühlkanälen 7 weist die Leuchte 1 eine Pumpe 10 auf. Die Pumpe 10 ist in Fig. 1 schematisch dargestellt und über eine ebenfalls schematisch dargestellte Fluidverbindung 11 mit den Kühlkanälen 7 verbunden. Bei dem gezeigten Ausführungsbeispiel ist die Pumpe 10 auf der ersten Substrat-Oberfläche 3 angeordnet. In weiteren, nicht dargestellten Ausführungsbeispielen ist die Pumpe 10 direkt in das Netzwerk der Kühlkanäle 7 integriert. In wiederum anderen, nicht dargestellten Ausführungsbeispielen ist die Pumpe 10 im Bereich der zweiten Substrat-Oberfläche 4 oder unabhängig von dem Substrat 2 angeordnet. Die Fluidverbindung 11 kann insbesondere durch das Substrat 2 oder von diesem weg führen.

Die Kühlkanäle 7 sind auf der ersten Substrat-Oberfläche 3 angeordnet. Die Kühlkanäle 7 sind in einer durch die erste Substrat-Oberfläche 3 gebildeten Ebene benachbart zu den LED-Leuchtmitteln 5 angeordnet. Die Kühlkanäle 7 grenzen umfangsseitig an die LED-Leuchtmittel 5 an. Die Kühlkanäle 7 sind umfangsseitig an allen vier Seiten der LED-Leuchtmittel 5 angeordnet. In der durch die erste Substrat-Oberfläche 3 gebildeten Ebene umschließen die Kühlkanäle 7 die einzelnen LED-Leuchtmittel 5 umfangseitig. Die Anordnung der Kühlkanäle 7 auf derselben Substrat-Oberfläche wie die LED-Leuchtmittel 5, nämlich auf der ersten Substrat-Oberfläche 3, hat insbesondere den Vorteil, dass die Kühlung der LED-Leuchtmittel 5 direkt und nicht über das Substrat 2 erfolgt. Hierdurch ist eine besonders effiziente Kühlung der LED-Leuchtmittel 5 durch die aktive Kühleinheit 6 gewährleistet.

Die LED-Leuchtmittel 5 sowie die Kühlkanäle 7 sind in einer transparenten Einkapselung 12 eingebettet. Die Kühlkanäle 7 sind als Hohlraum in der Einkapselung 12 ausgebildet. Die Kühlkanäle 7 weisen daher keine weitere Kühlkanal-Einhausung auf. Dies erleichtert die Fertigung der Kühlkanäle 7. Die Geometrie der Kühlkanäle 7, insbesondere deren Querschnitt, ist flexibel festlegbar.

Die Einkapselung 12 definiert eine bezogen auf die LED-Leuchtmittel 5 der ersten Substrat-Oberfläche 3 gegenüberliegende Abstrahl-Oberfläche 13. Mittels der LED-Leuchtmittel 5 erzeugtes Licht tritt aus der Abstrahl-Oberfläche 13 der Leuchte 1 aus. In dem gezeigten Ausführungsbeispiel ist die Abstrahl-Oberfläche 13 eben und parallel zu der ersten Substrat-Oberfläche 3. In anderen, nicht gezeigten Ausführungsbeispielen kann die Abstrahl-Oberfläche auch eine andere relative Lage zu der ersten Substrat-Oberfläche und/oder eine andere Form haben.

In Fig. 2 ist der Querschnitt der Kühlkanäle 7 der Leuchte 1 gezeigt. Die Kühlkanäle 7 weisen einen Querschnitt in Form eines gleichschenkligen Dreiecks auf. Die Basis des Dreiecks liegt in der durch die erste Substrat-Oberfläche 3 gebildeten Ebene. Die Schenkel des gleichschenkligen Dreiecks verlaufen unter einem Basiswinkel d von der ersten Substrat-Oberfläche 3 aus in Richtung der Abstrahl-Oberfläche 13. Die durch die Schenkel des gleichschenkligen Dreiecks definierten Ebenen weisen eine Flächennormale 16 und eine Oberflächentangente 17 auf. Die Oberflächentangente 17 verläuft parallel zu der Ebene des jeweiligen Schenkels. Der Basiswinkel d ist daher als der Winkel definiert, in welchem die Oberflächentangente 17 zu der ersten Substrat-Oberfläche 3 verläuft. Die Kühlkanäle 7 weisen in Richtung senkrecht zu der ersten Substrat-Oberfläche 3 eine Höhe H auf.

Die Kühlkanäle 7 weisen zu der Einkapselung 12 eine Kühlkanal-Grenzfläche 14 auf. In dem gezeigten Ausführungsbeispiel, in welchem die Kühlkanäle 7 durch Hohlräume in der Einkapselung 12 gebildet sind, ist die Kühlkanal-Grenzfläche 14 durch einen Übergang zwischen der Einkapselung 12 zu dem Kühlmittel 8 gebildet. In anderen, nicht dargestellten Ausführungsbeispielen kann die Kühlkanal-Grenzfläche 14 auch durch eine Kühlkanal-Einhausung ausgebildet sein.

Die Kühlkanal-Grenzfläche 14 verläuft entlang der Schenkel des dreieckförmigen Querschnitts der Kühlkanäle 7. Wie in Fig. 2 zu sehen ist, erstreckt sich ein einem der LED-Leuchtmittel 5 zugewandter Bereich der Kühlkanal-Grenzfläche 14 mit zunehmenden Abstand von der ersten Substrat-Oberfläche 3 von dem jeweils benachbarten LED-Leuchtmittel 5 weg. Mit anderen Worten nimmt ein in der Ebene der ersten Substrat-Oberfläche 3 gemessener Abstand der Kühlkanal-Grenzfläche 14 zu dem jeweils benachbarten LED-Leuchtmittel 5 mit zunehmendem Abstand senkrecht zu der ersten Substrat-Oberfläche 3 zu. Hierdurch definieren die Kühlkanäle 7, insbesondere deren Kühlkanal-Grenzflächen 14, einen sich von der ersten Substrat-Oberfläche 3 hin zu der Abstrahl-Oberfläche 13 öffnenden Lichtkegel für mittels der LED-Leuchtmittel 5 erzeugbares Licht.

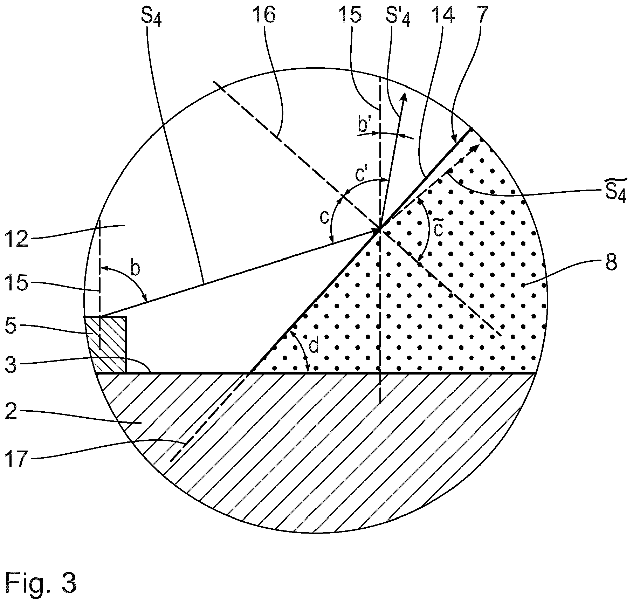

Mit Bezug auf die Fig. 2 und 3 wird im Folgenden die Abstrahlung von Licht mittels der Leuchte 1 beschrieben. Aufgrund der Anordnung der Kühlkanäle 7 ermöglichen diese eine Bündelung des mittels der LED-Leuchtmittel 5 erzeugten Lichts.

Senkrecht zu der ersten Substrat-Oberfläche 3 ist eine Hauptabstrahlrichtung 15 definiert. Bei dem gezeigten Ausführungsbeispiel steht die Hauptabstrahlrichtung 15 senkrecht auf die Abstrahl-Oberfläche 13. Die LED-Leuchtmittel 5 erzeugen Licht, welches von den LED-Leuchtmitteln 5 über den gesamten Raumwinkelbereich von $2\pi$ oberhalb der ersten Substrat-Oberfläche 3 abgestrahlt wird. Durch Pfeile sind in Fig. 2 Strahlengänge beispielhafter Lichtstrahlen $S_i$ mit i = 1, 2, 3, 4, die durch das in Fig. 2 mittig dargestellte LED-Leuchtmittel 5 erzeugbar sind.

Die Kühlkanäle 7 weisen in Richtung der Hauptabstrahlrichtung 15 keinen Überlapp mit den LED-Leuchtmitteln 5 auf. Die Kühlkanäle 7 sind daher nicht in einem Strahlengang von Lichtstrahlen angeordnet, die im Wesentlichen in Richtung der Hauptabstrahlrichtung 15 verlaufen. Von den beispielhaft in Fig. 2 gezeigten Strahlengängen treffen die Lichtstrahlen $S_1$, $S_2$, $S_3$ nicht auf die Kühlkanäle 7. Die Lichtstrahlen $S_1$, $S_2$, $S_3$ gelangen direkt an die Abstrahl-Oberfläche 13 und werden von dort in eine Umgebung der Leuchte 1 abgestrahlt. Die Kühlkanäle 7 sind jedoch in einem Strahlengang von zumindest einem Teil des mittels des mindestens einen LED-Leuchtmittels 5 erzeugten Lichts angeordnet. Von den beispielhaft in Fig. 2 gezeigten Lichtstrahlen trifft der Lichtstrahl $S_4$ auf den dem mittig dargestellten LED-Leuchtmittel 5 benachbarten Bereich der Kühlkanal-Grenzfläche 14 des in Fig. 2 rechts dargestellten Kühlkanals 7. Der Lichtstrahl $S_4$ wird an der Kühlkanal-Grenzfläche 14 in Richtung der Abstrahl-Oberfläche 13 reflektiert. Der reflektierte Lichtstrahl ist in den Fig. 2 und 3 als Lichtstrahl $S'_4$ eingezeichnet. Das auf die Kühlkanäle 7 treffende Licht wird an der Kühlkanal-Grenzfläche 14 umgelenkt. Die Umlenkung wird im Folgenden anhand der Fig. 3 im Detail beschrieben.

Der Lichtstrahl $S_4$ weist zu der Hauptabstrahlrichtung 15 einen Abstrahlwinkel b auf. Der Abstrahlwinkel b beträgt im Allgemeinen zwischen 0° und 90°. Beim Auftreffen auf die Kühlkanal-Grenzfläche 14 weist der Lichtstrahl $S_4$ zu einer Flächennormalen 16 der Kühlkanal-Grenzfläche 14 einen Einfallswinkel c auf. Der reflektierte Lichtstrahl $S'_4$ weist zu der Flächennormalen 16 einen Ausfallswinkel c' auf, wobei der Ausfallswinkel c' betragsmäßig dem Einfallswinkel c entspricht. Der Winkel zwischen dem reflektierten Lichtstrahl $S'_4$ und der Hauptabstrahlrichtung 15 wird mit b' bezeichnet. Aufgrund der Reflexion an der sich von dem LED-Leuchtmittel 5 weg erstreckenden Kühlkanal-Grenzfläche 14 gilt für den Winkel b': $0° \leq b' < b$. Aufgrund der Reflexion an der Kühlkanal-Grenzfläche 14 ist der Winkel b' des reflektierten Lichtstrahls $S'_4$ zu der Hauptabstrahlrichtung 15 im Vergleich zu dem Abstrahlwinkel b des Lichtstrahls $S_4$ verringert. Das an der Kühlkanal-Grenzfläche 14 reflektierte Licht erfährt eine Ablenkung in Richtung der Hauptabstrahlrichtung 15. Die Kühlkanäle 7 bewirken eine Umlenkung und Bündelung des mittels der LED-Leuchtmittel 5 erzeugten Lichts in Hauptabstrahlrichtung 15. Die Lichtintensität in Richtung der Hauptabstrahlrichtung 15 ist vergrößert.

Im Regelfall wird elektromagnetische Strahlung beim Auftreffen auf eine Grenzfläche nicht nur reflektiert, sondern wird teilweise durch die Grenzfläche transmittiert. In Fig. 3 ist daher auch ein transmittierter Lichtstrahl $\widetilde{S_4}$ des auf die Kühlkanal-Grenzfläche 14 treffenden Lichtstrahls $\widetilde{S_4}$ angedeutet. Der transmittierte Lichtstrahl $\widetilde{S_4}$ verläuft unter einem Transmissionswinkel $\tilde{c}$ zu der Flächennormalen 16. Der Transmissionswinkel $\tilde{c}$ bestimmt sich nach dem Gesetz von Snellius, wonach

$$n_E \sin c = n_K \sin \tilde{c} \qquad (3),$$

wobei $n_E$ der Brechungsindex der Einkapselung 12 und $n_K$ der Brechungsindex des Kühlmittels 8 ist. Da der Brechungsindex $n_E$ der Einkapselung 12 größer ist als der Brechungsindex $n_K$ des Kühlmittels 8, ist der Transmissionswinkel $\tilde{c}$ größer als der Einfallswinkel c. Durch eine Verminderung, insbesondere Vermeidung transmittierter Lichtstrahlen, kann die Intensität des Lichts in Hauptabstrahlrichtung 15 erhöht werden. Hierzu wird in der Leuchte 1 der Effekt der Totalreflexion genutzt, der beim Übergang vom optisch dichteren zum optisch dünneren Medium, also von einem Medium mit größerem Brechungsindex zu einem Medium mit geringerem Brechungsindex, ab einem gewissen Einfallswinkel c auftritt. Bei Totalreflexion beträgt der Winkel $\tilde{c} \geq 90°$. Abhängig von den Brechungsindizes der Einkapselung 12 bzw. des Kühlmittels 8 ist die Bedingung für den Einfallswinkel c, ab dem Totalreflexion auftritt, daher:

$$c \geq \sin^{-1}\left(\frac{n_K}{n_E}\right) \qquad (4).$$

Der Einfallswinkel c ist abhängig von dem Abstrahlwinkel b und dem Basiswinkel d. Je kleiner der Abstrahlwinkel b ist, desto größer ist der Einfallswinkel c. Bei dem gezeigten Ausführungsbeispiel ist der Basiswinkel d derart gewählt, dass unabhängig von dem Abstrahlwinkel b, insbesondere also auch für den Abstrahlwinkel b = 90°, der Einfallswinkel c zur Totalreflexion führt. Für den Basiswinkel d gilt daher die Bedingung:

$$d \leq 90° - \sin^{-1}\left(\frac{n_K}{n_E}\right) \qquad (5).$$

Der Brechungsindex der transparenten Einkapselung 12 liegt im gezeigten Ausführungsbeispiel zwischen 1,45 und 1,59. Bei dem gezeigten Ausführungsbeispiel wird für die transparente Einkapselung 12 ein Epoxidharz verwendet. Als Einkapselung wird beispielsweise das unter dem Handelsnamen "Nitto Denko NT-8524" vertriebene Epoxidharz verwendet, das einen Brechungsindex von 1,57 aufweist.

Als Kühlmittel 8 sind verschiedene Fluide, insbesondere Flüssigkeiten einsetzbar. Ein beispielhaftes Kühlmittel ist Ethylenglycol, das einen Brechungsindex von 1,43 aufweist. Für $n_E$ = 1,57 und $n_K$ = 1,43 ergibt sich gemäß Formel (5) für den Basiswinkel d, ab welchem die Totalreflexion unabhängig von dem Abstrahlwinkel b gewährleistet ist: d $\leq$ 21,7°. Ein alternatives Kühlmittel ist Wasser, das einen Brechungsindex von 1,33 hat. In diesem Fall ergibt sich für den Basiswinkel d, für den die Totalreflexion unabhängig von dem Abstrahlwinkel b gewährleistet ist: d $\leq$ 32°.

In alternativen, nicht gezeigten Ausführungsbeispielen ist die transparente Einkapselung aus einem Silikon-Elastomer. Ein beispielhaftes Silikon-Elastomer, das unter dem Handelsnamen "Dow Corning OE-6550" vertrieben wird, hat den Brechungsindex 1,54.

Die Kühlkanäle 7 weisen senkrecht zu der ersten Substrat-Oberfläche 3 und damit in Hauptabstrahlrichtung 15 eine Höhe H auf. Die Höhe H ist abhängig von einer Breite B der Basis des dreieckigen Querschnitts der Kühlkanäle 7 und dem Basiswinkel d. Mit Vergrößerung des Basiswinkels d und/oder Erhöhung der Breite B vergrößert sich die Höhe H. Mit steigender Höhe trifft ein größerer Anteil des mittels der LED-Leuchtmittel 5 erzeugten Lichts auf die Kühlkanal-Grenzfläche 14 und wird an dieser umgelenkt. Die mittels der Kühlkanäle 7 bewirkte Bündelungswirkung ist daher abhängig von der Höhe H und dem Basiswinkel d des Querschnitts des Kühlkanals 7. Die Lichtintensität und Bündelung des durch die Leuchte 1 abgestrahlten Lichts entlang der Hauptabstrahlrichtung 15 ist daher durch die Geometrie der Kühlkanäle 7 einstellbar. Die Höhe H beträgt beispielsweise zwischen 1 mm und 20 mm, insbesondere zwischen 1 mm und 15 mm, bevorzugt etwa 10 mm. Die Breite der Kühlkanäle 7 beträgt beispielsweise zwischen 5 mm und 50 mm, insbesondere zwischen 5 mm und 40 mm, bevorzugt etwa 20 mm. Der Basiswinkel d beträgt beispielsweise zwischen 0° und 90°, insbesondere zwischen 10° und 80°, insbesondere zwischen 15° und 45°, bevorzugt etwa 35°.

Weitere Parameter zur Beeinflussung der Abstrahlcharakteristik sind die in Richtung der ersten Substrat-Oberfläche 3 gemessene Ausdehnung L der LED-Leuchtmittel 5 sowie der in Richtung der ersten Substrat-Oberfläche 3 gemessene Abstand A zwischen den Kühlkanälen 7 und den LED-Leuchtmitteln 5 (vgl. Fig. 2). Der Abstand A kann beispielsweise zwischen 0 mm und 5 mm, insbesondere zwischen 0,5 mm und 2 mm, insbesondere etwa 1 mm betragen. Bei einem Abstand A = 0 mm sind die LED-Leuchtmittel 5 und die Kühlkanäle 7 direkt zueinander benachbart auf der ersten Substrat-Oberfläche 3 angeordnet. Eine beispielhafte Ausdehnung L der LED-Leuchtmittel 5 kann zwischen 0,1 mm und 5 mm, insbesondere zwischen 0,2 mm und 2 mm, insbesondere etwa 1 mm betragen. In einem exemplarischen Ausführungsbeispiel beträgt die Ausdehnung der LED-Leuchtmittel 5 etwa 1 mm und der Abstand zwischen LED-Leuchtmittel 5 und den benachbarten Kühlkanälen 7 jeweils 1 mm. In dem exemplarischen Ausführungsbeispiel beträgt der Basiswinkel d = 35°, die Höhe H = 7,5 mm und die Breite B = 21 mm.

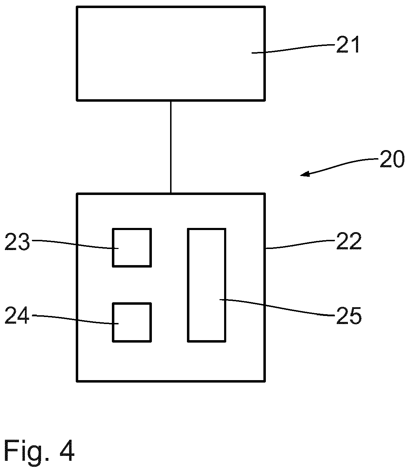

In Fig. 4 ist der Ablauf eines Betriebsverfahrens 20 für die Leuchte 1 schematisch dargestellt. In einem Bereitstellungsschritt 21 wird die Leuchte 1 bereitgestellt.

An den Bereitstellungsschritt 21 schließt sich ein Abstrahlschritt 22 an. In dem Abstrahlschritt 22 wird mit Hilfe der Leuchte 1 Licht abgestrahlt. Das abzustrahlende Licht wird in einem Lichterzeugungsschritt 23 mit Hilfe der LED-Leuchtmittel 5 erzeugt. Das mit Hilfe der LED-Leuchtmittel 5 erzeugte Licht ist im sichtbaren Bereich. In einem Umlenkschritt 24 wird zumindest ein Teil des mit Hilfe der LED-Leuchtmittel 5 erzeugten Lichts durch die Kühlkanäle 7 umgelenkt. Hierbei wird das Licht an einer Kühlkanal-Grenzfläche 14 reflektiert, insbesondere totalreflektiert.

In einem Kühlschritt 25 werden die LED-Leuchtmittel 5 mit Hilfe der aktiven Kühleinheit 6 gekühlt. Hierbei wird Kühlmittel 8 durch die Kühlkanäle 7 mit Hilfe der Pumpe 10 gepumpt.

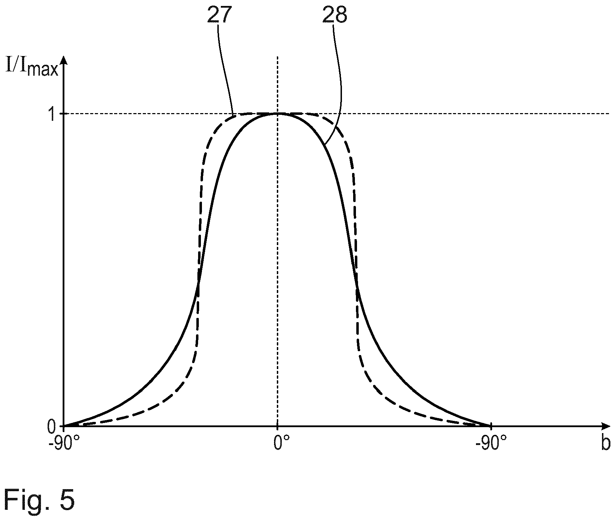

In Fig. 5 wird schematisch die Abstrahlcharakteristik 27 der Leuchte 1 gezeigt. Die Intensität I des mittels eins LED-Leuchtmittels erzeugten Lichts variiert mit dem Abstrahlwinkel b. Zur Ermittlung der Abstrahlcharakteristik 27 wird die auf die maximale Intensität $I_{max}$ normierte Intensität I über den Abstrahlwinkel b aufgetragen. Die Abstrahlcharakteristik 27 ist als gestrichelte Linie dargestellt. Zu Vergleichszwecken ist auch eine Referenz-Abstrahlcharakteristik 28 als durchgezogene Linie in Fig. 5 schematisch dargestellt. Die Referenz-Abstrahlcharakteristik 28 entspricht der Abstrahlcharakteristik einer Referenz-Leuchte, die keine Kühlkanäle 7 auf der ersten Substrat-Oberfläche 3 aufweist, ansonsten aber wie die Leuchte 1 ausgebildet ist. Bei der Referenz-Leuchte, deren Aufbau dem Aufbau marktüblicher LED-Lampen entspricht, findet keine Umlenkung eines Teils des mittels der LED-Leuchtmittel erzeugten Lichts an Kühlkanälen statt. Der Vergleich der Abstrahlcharakteristik 27 mit der Referenz-Abstrahlcharakteristik 28 zeigt deutlich, dass durch die Umlenkung eines Teils des mittels der LED-Leuchtmittel 5 erzeugten Lichts an den Kühlkanälen 7 eine Bündelung des Lichts um die Hauptabstrahlrichtung 15, für die b = 0° gilt, erfolgt. Insbesondere weist die Abstrahlcharakteristik 27 im Vergleich mit der Referenz-Abstrahlcharakteristik 28 eine erhöhte Intensität I für kleine Beträge des Abstrahlwinkels b auf. Für größere Beträge des Abstrahlwinkels b, insbesondere in den Bereichen nahe von 90° bzw. - 90° ist die Intensität I der Abstrahlcharakteristik 27 gegenüber der Referenz-Abstrahlcharakteristik 28 verringert.

In weiteren, nicht gezeigten Ausführungsbeispielen ist der Basiswinkel d und/oder das Verhältnis der Brechungsindizes $n_K/n_E$ derart gewählt, dass die Bedingung in Formel (5) nicht erfüllt ist. Die Totalreflexion ist daher nicht für alle Abstrahlwinkel b gewährleistet. Bei derartigen Ausführungsbeispielen erfolgt die Totalreflexion nur für Lichtstrahlen, für deren Abstrahlwinkel b gilt

$$b \leq 180° - d - \sin^{-1}\left(\frac{n_K}{n_E}\right) \qquad (6).$$

In weiteren Ausführungsbeispielen weisen die Kühlkanäle 7 eine andere Querschnittsgeometrie auf. Die Kühlkanäle 7 weisen beispielsweise einen polygonförmigen Querschnitt auf. Polygonförmige Querschnitte haben den Vorteil ebener Bereiche der Kühlkanal-Grenzfläche 14, sodass eine kontrollierte Umlenkung des hierauf einfallenden Lichts gewährleistet ist.

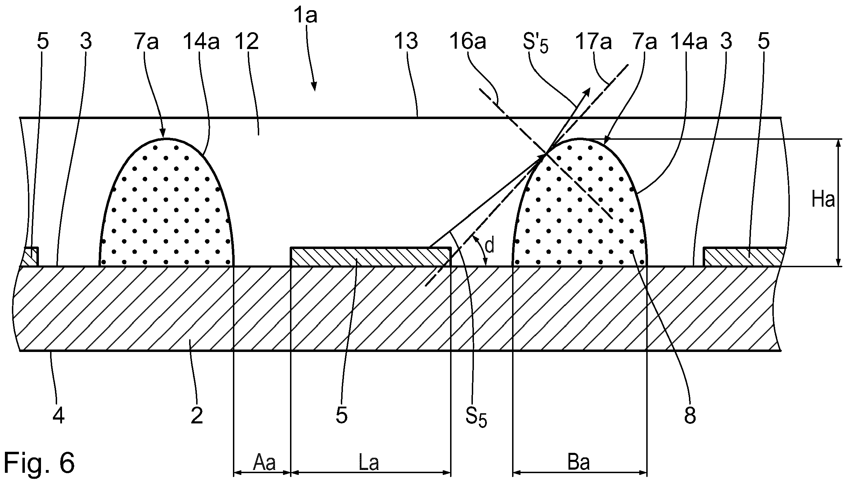

In Fig. 6 ist ein alternatives Ausführungsbeispiel einer Leuchte 1a gezeigt. Komponenten, die im Zusammenhang mit dem Ausführungsbeispiel in den Fig. 1 bis 3 bereits beschrieben wurden, tragen die gleichen Bezugszeichen. Konstruktiv unterschiedliche, jedoch funktional gleiche Komponenten tragen das gleiche Bezugszeichen mit einem nachgestellten a.

Die Leuchte 1a unterscheidet sich von der in den Fig. 1 bis 3 gezeigten Leuchte 1 nur durch die Geometrie der Kühlkanäle 7a. Die Kühlkanäle 7a weisen einen kuppelartigen Querschnitt auf. Mit dem kuppelartigen Querschnitt der Kühlkanäle 7a ist eine große Höhe Ha auch bei geringer Breite Ba der Kühlkanäle 7a möglich. Der kuppelförmige Querschnitt weist zwei im Wesentlichen geradlinig sich von der ersten Substrat-Oberfläche 3 weg erstreckende Seitenabschnitte auf. An ihrem der ersten Substrat-Oberfläche 3 abgewandten Ende weisen die Kühlkanäle 7a eine abgerundete Spitze auf.

Im Gegensatz zu dem in Fig. 3 gezeigten, dreieckigen Querschnitt des Kühlkanals 7 weisen Seitenwände die Kühlkanal-Grenzfläche 14a des Kühlkanals 7a keinen einheitlichen Basiswinkel d auf. Der Basiswinkel d ist daher bereichsweise definiert als der Winkel, unter welchem eine Oberflächentangente 17a des jeweiligen Bereichs der Kühlkanal-Grenzfläche 14a zu der ersten Substrat-Oberfläche 3 verläuft.

Im Bereich der Spitze der Kühlkanäle 7a ist der Basiswinkel d klein genug, die Gleichung (5) zu erfüllen. In diesem Bereich ist der Einfallswinkel c in Bezug auf die Flächennormale 16a groß genug, um Totalreflexion zu erzeugen, wie dies an dem beispielhaften Lichtstrahl $S_5$ in Fig. 6 dargestellt ist.

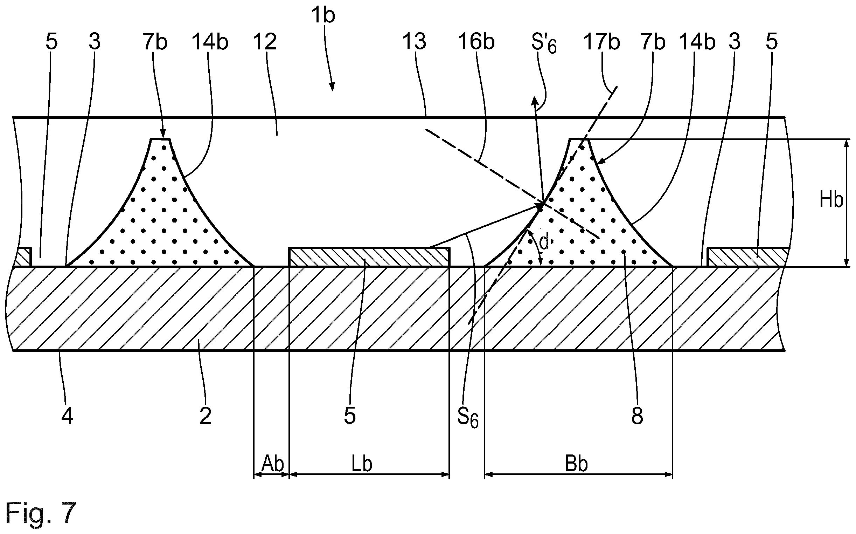

In Fig. 7 ist ein weiteres alternatives Ausführungsbeispiel einer Leuchte 1b gezeigt. Komponenten, die im Zusammenhang mit dem Ausführungsbeispiel in den Fig. 1 bis 3 bereits beschrieben wurden, tragen die gleichen Bezugszeichen. Konstruktiv unterschiedliche, jedoch funktional gleiche Komponenten tragen das gleiche Bezugszeichen mit einem nachgestellten b.

Die Leuchte 1b unterscheidet sich von der in den Fig. 1 bis 3 gezeigten Leuchte 1 bzw. von der in Fig. 6 gezeigten Leuchte 1a nur durch die Geometrie der Kühlkanäle 7b. Die Kühlkanäle 7b weisen einen keilförmigen Querschnitt auf. Die den LED-Leuchtmitteln 5 zugewandten Bereiche der Kühlkanal-Grenzfläche 14b sind konkav gekrümmt. Insgesamt weist der Kühlkanal 7b hierdurch einen im Wesentlichen linsenförmigen Querschnitt auf. Durch die konkave Krümmung der den LED-Leuchtmitteln 5 zugewandten Bereiche der Kühlkanal-Grenzfläche 14b nimmt der Basiswinkel d mit abnehmendem Abstand von der ersten Substrat-Oberfläche 3 ab. Dies gewährleistet, dass Lichtstrahlen mit großem Abstrahlwinkel b auf Bereiche der Kühlkanal-Grenzfläche 14b treffen, die einen kleinen Basiswinkel d aufweisen. Hierdurch kann auf effiziente Weise die Bedingung für Totalreflexion an der Kühlkanal-Grenzfläche 14b gewährleistet werden. Die Kühlkanäle 7b ermöglichen eine besonders effiziente Bündelung des mittels der LED-Leuchtmittel 5 erzeugten Lichts. In Fig. 7 ist ein beispielhafter Lichtstrahl $S_6$ gezeigt, der an der Kühlkanal-Grenzfläche 14b total reflektiert wird.

Um die Reflexion der Lichtstrahlen an den Kühlkanälen zu verbessern, ist in weiteren, nicht dargestellten Ausführungsbeispielen eine Reflexionsschicht an der Kühlkanal-Grenzfläche vorhanden. In einigen Ausführungsbeispielen ist die Kühlkanal-Grenzfläche hierzu mit einem reflektierenden Material beschichtet. In wiederum anderen Ausführungsbeispielen weisen die Kühlkanäle eine Kühlkanal-Einhausung mit reflektierender Oberfläche auf. Eine Reflexionsschicht ist insbesondere dann von Vorteil, wenn der Basiswinkel d nicht für alle dem jeweils benachbarten LED-Leuchtmittel 5 zugewandte Bereiche der Kühlkanal-Grenzfläche die Bedingung der Formel (5) erfüllt, beispielsweise bei der in Fig. 6 gezeigten Querschnittsform der Kühlkanäle 7a.

Alternative Ausführungsbeispiele betreffen Strahler zur Abstrahlung von Infrarotlicht oder UV-Licht. Die Strahler können wie die oben beschriebenen Leuchten ausgebildet sein, wobei die entsprechenden LED-Elemente zur Erzeugung von Infrarotlicht bzw. UV-Licht ausgelegt sind. Das abzustrahlende Licht wird durch die jeweiligen Kühlkanäle zumindest teilweise umgelenkt ohne eine Frequenzänderung zu erfahren.

**Patentansprüche**

1. Strahler zum Abstrahlen von Licht, aufweisend

   - ein Substrat (2) mit einer Substrat-Oberfläche (3),
   - mindestens ein auf der Substrat-Oberfläche (3) angeordnetes LED-Element (5) zur Erzeugung des abzustrahlenden Lichts, und
   - eine aktive Kühleinheit (6) zur Kühlung des mindestens einen LED-Elements (5) mit mindestens einem Kühlkanal (7; 7a; 7b) für ein Kühlmittel (8),

   wobei der mindestens eine Kühlkanal (7; 7a; 7b) in einem Strahlengang ($S_4$; $S_5$; $S_6$) von zumindest einem Teil des mittels des mindestens einen LED-Elements (5) erzeugbaren abzustrahlenden Lichts zur Umlenkung des abzustrahlenden Lichts angeordnet ist,
   wobei die Umlenkung des abzustrahlenden Lichts ohne Änderung einer Frequenz des abzustrahlenden Lichts erfolgt,
   wobei das mindestens eine LED-Element (5) und der mindestens eine Kühlkanal (7; 7a; 7b) in einer transparenten Einkapselung (12) eingebettet sind,
   **dadurch gekennzeichnet, dass** die Einkapselung (12) ein Silikon-Elastomer und/oder ein Harz aufweist.

2. Strahler nach Anspruch 1, **dadurch gekennzeichnet,**
   **dass** durch den mindestens einen Kühlkanal (7; 7a; 7b) zumindest ein Teil des abzustrahlenden Lichts in Richtung einer vordefinierten Hauptabstrahlrichtung (15), insbesondere einer senkrecht zu der Substrat-Oberfläche (3) definierten Hauptabstrahlrichtung (15), ablenkbar ist.

3. Strahler nach mindestens einem der vorgenannten Ansprüche, **dadurch gekennzeichnet,**
   **dass** eine Kühlkanal-Grenzfläche (14; 14a; 14b) des mindestens einen Kühlkanals (7; 7a; 7b) zumindest bereichsweise derart ausgebildet ist, dass zumindest ein Teil des abzustrahlenden Lichts an der Kühlkanal-Grenzfläche (14; 14a; 14b) reflektiert wird.

4. Strahler mindestens nach einem der vorgenannten Ansprüche, **dadurch gekennzeichnet,**
   **dass** der mindestens eine Kühlkanal (7; 7a; 7b) auf einer durch die Substrat-Oberfläche (3) gebildeten Ebene benachbart zu dem mindestens einen LED-Element (5) angeordnet ist.

5. Strahler nach Anspruch 4, **dadurch gekennzeichnet,**
   **dass** das mindestens eine LED-Element (5) an mindestens zwei Seiten auf der durch die Substrat-Oberfläche (3) definierten Ebene an den mindestens einen Kühlkanal (7; 7a; 7b) angrenzt.

6. Strahler nach einem der Ansprüche 4 oder 5, **dadurch gekennzeichnet,**
   **dass** ein dem jeweils benachbarten LED-Element (5) zugewandter Bereich einer Kühlkanal-Grenzfläche (14; 14a; 14b) des mindestens einen Kühlkanals (7; 7a; 7b) sich mit zunehmendem Abstand von der Substrat-Oberfläche (3) von dem benachbarten LED-Element (5) wegerstreckt.

7. Strahler nach mindestens einem der vorgenannten Ansprüche, **dadurch gekennzeichnet,**
   **dass** der mindestens eine Kühlkanal (7; 7a; 7b) als Hohlraum in der Einkapselung (12) ausgebildet ist.

8. Strahler nach mindestens einem der vorgenannten Ansprüche, **dadurch gekennzeichnet,**
   **dass** die Einkapselung (12) ein Epoxidharz aufweist.

9. Strahler nach mindestens einem der vorgenannten Ansprüche, **dadurch gekennzeichnet,**
   **dass** ein Brechungsindex $n_E$ der transparenten Einkapselung (12) größer als ein Brechungsindex $n_K$ eines in dem mindestens einen Kühlkanal (7; 7a; 7b) enthaltenen Kühlmittels (8) ist.

10. Strahler nach Anspruch 9, **dadurch gekennzeichnet,**
    **dass** eine Oberflächentangente (17; 17a; 17b) eines dem mindestens einen LED-Element (5) zugewandten Bereichs einer Kühlkanal-Grenzfläche (14; 14a; 14b) des mindestens einen Kühlkanals (7; 7a; 7b) unter einem Winkel d zu der Substrat-Oberfläche (3) verläuft, wobei gilt:

$$d \leq 90° - \sin^{-1}(n_K/n_E).$$

11. Strahler nach mindestens einem der vorgenannten Ansprüche, **dadurch gekennzeichnet,**
    **dass** ein Querschnitt des mindestens einen Kühlkanals (7) polygonförmig, insbesondere dreieckig, ist.

12. Strahler nach mindestens einem der vorgenannten Ansprüche, **dadurch gekennzeichnet,**
    **dass** der mindestens eine Kühlkanal (7; 7a; 7b) ein Ethylenglycol aufweisendes Kühlmittel (8) enthält.

13. Verfahren zum Abstrahlen von Licht mittels eines Strahlers mit den Schritten:

    - Bereitstellen eines Strahlers (1; 1a; 1b), aufweisend

        -- ein Substrat (2) mit einer Substrat-Oberfläche (3),
        -- mindestens ein auf der Substrat-Oberfläche (3) angeordnetes LED-Element (5) zur Erzeugung von abzustrahlenden Licht, und
        -- eine aktive Kühleinheit (6) zur Kühlung des mindestens einen LED-Elements (5) mit mindestens einem Kühlkanal (7; 7a; 7b) für ein Kühlmittel (8),

    wobei der mindestens eine Kühlkanal (7; 7a; 7b) in einem Strahlengang ($S_4$; $S_5$; $S_6$) von zumindest einem Teil des mittels des mindestens einen LED-Elements (5) erzeugbaren abzustrahlenden Lichts angeordnet ist, wobei das mindestens eine LED-Element (5) und der mindestens eine Kühlkanal (7; 7a; 7b) in einer transparenten Einkapselung (12) eingebettet sind, und wobei die Einkapselung (12) ein Silikon-Elastomer und/oder ein Harz aufweist,
    - Erzeugen des abzustrahlenden Lichts mittels des mindestens einen LED-Elements (5),
    - Kühlen des mindestens einen LED-Elements (5) mittels der aktiven Kühleinheit (6) und
    - Umlenken mindestens eines Teils des abzustrahlenden Lichts mittels des mindestens einen Kühlkanals (7;

7a; 7b),

wobei die Umlenkung des abzustrahlenden Lichts ohne Änderung einer Frequenz des abzustrahlenden Lichts erfolgt.

**14.** Verfahren nach Anspruch 13, **dadurch gekennzeichnet,**
**dass** mindestens ein Teil des abzustrahlenden Lichts durch den mindestens einen Kühlkanal (7; 7a; 7b) in Richtung einer vordefinierten Hauptabstrahlrichtung (15), insbesondere in Richtung einer senkrecht zu der Substrat-Oberfläche (3) definierten Hauptabstrahlrichtung (15), abgelenkt wird.

**15.** Verfahren nach einem der Ansprüche 13 oder 14, **dadurch gekennzeichnet,**
**dass** die Umlenkung mindestens eines Teils des abzustrahlenden Lichts durch Reflexion, insbesondere Totalreflexion an einer Kühlkanal-Grenzfläche (14; 14a; 14b) des mindestens einen Kühlkanals (7; 7a; 7b) erfolgt.

## Claims

**1.** Emitter for emitting light, comprising

- a substrate (2) having a substrate surface (3),
- at least one LED element (5) arranged on the substrate surface (3) for generating the light to be emitted, and
- an active cooling unit (6) for cooling the at least one LED element (5) comprising at least one cooling channel (7; 7a; 7b) for a coolant (8),

wherein the at least one cooling channel (7; 7a; 7b) is arranged in a beam path ($S_4$; $S_5$; $S_6$) of at least a part of the light to be emitted which can be generated by means of the at least one LED element (5), for redirecting the light to be emitted,
wherein the redirection of the light to be emitted takes place without changing a frequency of the light to be emitted,
wherein the at least one LED element (5) and the at least one cooling channel (7; 7a; 7b) are embedded in a transparent encapsulation (12), **characterized in that** the encapsulation (12) has a silicone elastomer and/or a resin.

**2.** Emitter according to claim 1, **characterized in that** at least a part of the light to be emitted can be redirected by the at least one cooling channel (7; 7a; 7b) in the direction of a predefined main emission direction (15), in particular a main emission direction (15) defined perpendicularly to the substrate surface (3).

**3.** Emitter according to at least one of the preceding claims, **characterized in that** a cooling channel interface (14; 14a; 14b) of the at least one cooling channel (7; 7a; 7b) is formed, at least in regions, in such a way that at least a part of the light to be emitted is reflected at the cooling channel interface (14; 14a; 14b).

**4.** Emitter at least according to one of the preceding claims, **characterized in that** the at least one cooling channel (7; 7a; 7b) is arranged on a plane formed by the substrate surface (3) adjacent to the at least one LED element (5).

**5.** Emitter according to claim 4, **characterized in that** the at least one LED element (5) is adjacent to the at least one cooling channel (7; 7a; 7b) on at least two sides on the plane defined by the substrate surface (3).

**6.** Emitter according to one of the claims 4 or 5, **characterized in that** a region of a cooling channel interface (14; 14a; 14b) of the at least one cooling channel (7; 7a; 7b) facing the respective adjacent LED element (5) extends away from the adjacent LED element (5) with increasing distance from the substrate surface (3).

**7.** Emitter according to at least one of the preceding claims, **characterized in that** the at least one cooling channel (7; 7a; 7b) is formed as a cavity in the encapsulation (12).

**8.** Emitter according to at least one of the preceding claims, **characterized in that** the encapsulation (12) has an epoxy resin.

**9.** Emitter according to at least one of the preceding claims, **characterized in that** a refractive index $n_E$ of the transparent encapsulation (12) is greater than a refractive index $n_K$ of a coolant (8) contained in the at least one cooling channel (7; 7a; 7b).

10. Emitter according to claim 9, **characterized in**
**that** a surface tangent (17; 17a; 17b) of a region of a cooling channel interface (14; 14a; 14b) of the at least one cooling channel (7; 7a; 7b) facing the at least one LED element (5) runs at an angle d to the substrate surface (3), wherein:

$$d \leq 90° - \sin^{-1}(n_K/n_E).$$

11. Emitter according to at least one of the preceding claims, **characterized in**
**that** a cross-section of the at least one cooling channel (7) is polygonal, in particular triangular.

12. Emitter according to at least one of the preceding claims, **characterized in**
**that** the at least one cooling channel (7; 7a; 7b) contains a coolant (8) having ethylene glycol.

13. Method for emitting light by means of an emitter comprising the steps of:

- providing an emitter (1; 1a; 1b), having

-- a substrate (2) with a substrate surface (3),
-- at least one LED element (5) arranged on the substrate surface (3) for generating light to be emitted, and
-- an active cooling unit (6) for cooling the at least one LED element (5) with at least one cooling channel (7; 7a; 7b) for a coolant (8),

wherein the at least one cooling channel (7; 7a; 7b) is arranged in a beam path ($S_4$; $S_5$; $S_6$) of at least a part of the light to be emitted which can be generated by means of the at least one LED element (5),
wherein the at least one LED element (5) and the at least one cooling channel (7; 7a; 7b) are embedded in a transparent encapsulation (12), and
wherein the encapsulation (12) has a silicone elastomer and/or a resin,
- generating the light to be emitted by means of the at least one LED element (5),
- cooling of the at least one LED element (5) by means of the active cooling unit (6) and
- redirecting at least a part of the light to be emitted by means of the at least one cooling channel (7; 7a; 7b),

wherein the redirection of the light to be emitted takes place without changing a frequency of the light to be emitted.

14. Method according to claim 13, **characterized in**
**that** at least a part of the light to be emitted is redirected by the at least one cooling channel (7; 7a; 7b) in the direction of a predefined main emission direction (15), in particular in the direction of a main emission direction (15) defined perpendicularly to the substrate surface (3).

15. Method according to any one of claims 13 or 14, **characterized in**
**that** the redirection of at least a part of the light to be emitted takes place by reflection, in particular total reflection, at a cooling channel interface (14; 14a; 14b) of the at least one cooling channel (7; 7a; 7b).

**Revendications**

1. Emetteur pour émettre de la lumière, présentant

- un substrat (2) ayant une surface de substrat (3),
- au moins un élément LED (5) disposé sur la surface du substrat (3), pour générer la lumière à émettre, et
- une unité de refroidissement active (6) pour refroidir l'au moins un élément LED (5), ayant au moins un canal de refroidissement (7 ; 7a ; 7b) pour un agent réfrigérant (8),

dans lequel l'au moins un canal de refroidissement (7 ; 7a ; 7b) est disposé dans un trajet de faisceau ($S_4$ ; $S_5$ ; $S_6$) d'au moins une partie de la lumière à émettre qui peut être générée au moyen de l'au moins un élément LED (5), pour rediriger la lumière à émettre,

dans lequel la redirection de la lumière à émettre est effectuée sans changer une fréquence de la lumière à émettre, dans lequel l'au moins un élément LED (5) et l'au moins un canal de refroidissement (7 ; 7a ; 7b) sont incorporés dans une encapsulation transparente (12),
**caractérisé en ce que** l'encapsulation (12) présente un élastomère de silicone et/ou une résine.

2. Emetteur selon la revendication 1, **caractérisé en ce**
**qu'**au moins une partie de la lumière à émettre peut être redirigée par l'au moins un canal de refroidissement (7 ; 7a ; 7b) en direction d'une direction d'émission principale prédéfinie (15), en particulier une direction d'émission principale (15) définie perpendiculairement à la surface du substrat (3).

3. Emetteur selon au moins une des revendications précédentes, **caractérisé en ce**
**qu'**une interface de canal de refroidissement (14 ; 14a ; 14b) de l'au moins un canal de refroidissement (7 ; 7a ; 7b) est formée, au moins par zones, de telle sorte qu'au moins une partie de la lumière à émettre est réfléchie au niveau de l'interface du canal de refroidissement (14 ; 14a ; 14b).

4. Emetteur au moins selon une des revendications précédentes, **caractérisé en ce**
**que** l'au moins un canal de refroidissement (7 ; 7a ; 7b) est disposé sur un plan formé par la surface du substrat (3) adjacent à l'au moins un élément LED (5).

5. Emetteur selon la revendication 4, **caractérisé en ce**
**que** l'au moins un élément LED (5) est adjacent à l'au moins un canal de refroidissement (7 ; 7a ; 7b) sur au moins deux côtés sur le plan défini par la surface du substrat (3).

6. Emetteur selon l'une quelconque des revendications 4 ou 5, **caractérisé en ce**
**qu'**une région d'une interface de canal de refroidissement (14 ; 14a ; 14b) de l'au moins un canal de refroidissement (7 ; 7a ; 7b), qui fait face à l'élément LED (5) respectivement adjacent, s'étend en s'éloignant de l'élément LED (5) adjacent avec une distance croissante de la surface du substrat (3).

7. Emetteur selon au moins une des revendications précédentes, **caractérisé en ce**
**que** l'au moins un canal de refroidissement (7 ; 7a ; 7b) est formé comme une cavité dans l'encapsulation (12).

8. Emetteur selon au moins une des revendications précédentes, **caractérisé en ce**
**que** l'encapsulation (12) présente une résine époxy.

9. Emetteur selon au moins une des revendications précédentes, **caractérisé en ce**
**qu'**un indice de réfraction $n_E$ de l'encapsulation transparente (12) est plus grand qu'un indice de réfraction $n_K$ d'un agent réfrigérant (8) contenu dans l'au moins un canal de refroidissement (7 ; 7a ; 7b).

10. Emetteur selon la revendication 9, **caractérisé en ce**
**qu'**une tangente de surface (17 ; 17a ; 17b) d'une région d'une interface de canal de refroidissement (14 ; 14a ; 14b) de l'au moins un canal de refroidissement (7 ; 7a ; 7b) tournée vers l'au moins un élément LED (5) s'étend selon un angle d par rapport à la surface du substrat (3), où

$$d \leq 90° - \sin^{-1}(n_K/n_E).$$

11. Emetteur selon au moins une des revendications précédentes, **caractérisé en ce**
**qu'**une section transversale de l'au moins un canal de refroidissement (7) est polygonale, en particulier triangulaire.

12. Emetteur selon au moins une des revendications précédentes, **caractérisé en ce**
**que** l'au moins un canal de refroidissement (7 ; 7a ; 7b) contient un agent réfrigérant (8) présentant de l'éthylène glycol.

13. Procédé d'émission de lumière au moyen d'un émetteur comprenant les étapes suivantes :

    mise à disposition d'un émetteur (1 ; 1a ; 1b), présentant

        -- un substrat (2) ayant une surface de substrat (3),

-- au moins un élément LED (5) disposé sur la surface du substrat (3) pour générer de la lumière à émettre, et
-- une unité de refroidissement active (6) pour refroidir l'au moins un élément LED (5), ayant au moins un canal de refroidissement (7 ; 7a ; 7b) pour un agent réfrigérant (8),

dans lequel l'au moins un canal de refroidissement (7 ; 7a ; 7b) est disposé dans un trajet de faisceau ($S_4$ ; $S_5$ ; $S_6$) d'au moins une partie de la lumière à émettre qui peut être générée au moyen de l'au moins un élément LED (5),
dans lequel l'au moins un élément LED (5) et l'au moins un canal de refroidissement (7 ; 7a ; 7b) sont incorporés dans une encapsulation transparente (12), et
dans lequel l'encapsulation (12) présente un élastomère de silicone et/ou une résine,
- génération de la lumière à émettre au moyen de l'au moins un élément LED (5),
- refroidissement de l'au moins un élément LED (5) au moyen de l'unité de refroidissement active (6) et
- redirection d'au moins une partie de la lumière à émettre au moyen de l'au moins un canal de refroidissement (7 ; 7a ; 7b),

dans lequel la redirection de la lumière à émettre est effectuée sans changer une fréquence de la lumière à émettre.

**14.** Procédé selon la revendication 13, **caractérisé en ce qu'**au moins une partie de la lumière à émettre est redirigée par l'au moins un canal de refroidissement (7 ; 7a ; 7b) en direction d'une direction d'émission principale prédéfinie (15), en particulier en direction d'une direction d'émission principale (15) définie perpendiculairement à la surface du substrat (3).

**15.** Procédé selon l'une quelconque des revendications 13 ou 14, **caractérisé en ce que** la redirection d'au moins une partie de la lumière à émettre est effectuée par réflexion, en particulier par réflexion totale, au niveau d'une interface de canal de refroidissement (14 ; 14a ; 14b) de l'au moins un canal de refroidissement (7 ; 7a ; 7b).

Fig. 1

EP 3 810 988 B1

Fig. 2

EP 3 810 988 B1

Fig. 3

Fig. 4

Fig. 5

EP 3 810 988 B1

Fig. 6

EP 3 810 988 B1

Fig. 7

EP 3 810 988 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1681728 A1
- DE 102007054039 A1
- DE 102010007687 A1
- US 20050094397 A1
- US 20080191236 A1
- US 20030052584 A1
- US 20170009961 A1
- EP 1780804 A1
- US 20120044678 A1